(19) Europäisches Patentamt
European Patent Office
Office européen des brevets

(11) Veröffentlichungsnummer : **0 321 855 B1**

(12) # EUROPÄISCHE PATENTSCHRIFT

(45) Veröffentlichungstag der Patentschrift : **18.09.91 Patentblatt 91/38**

(51) Int. Cl.$^5$ : **C23C 18/20**

(21) Anmeldenummer : **88120957.1**

(22) Anmeldetag : **15.12.88**

(54) **Polymere Konditionierungsmittel zur Vorbehandlung von nichtmetallischen Oberflächen für eine chemische Metallisierung.**

(30) Priorität : **23.12.87 DE 3743741**

(43) Veröffentlichungstag der Anmeldung : **28.06.89 Patentblatt 89/26**

(45) Bekanntmachung des Hinweises auf die Patenterteilung : **18.09.91 Patentblatt 91/38**

(84) Benannte Vertragsstaaten : **CH DE ES FR GB IT LI NL SE**

(56) Entgegenhaltungen :
**EP-A- 0 102 209**
**EP-A- 0 213 542**

(73) Patentinhaber : **BASF Aktiengesellschaft
Carl-Bosch-Strasse 38
W-6700 Ludwigshafen (DE)**

(72) Erfinder : **Tschang, Chung-ji, Dr.
Hinterbergstrasse 31
W-6702 Bad Duerkheim (DE)**
Erfinder : **Dix, Johannes Peter, Dr.
Ludwigshafener Strasse 125
W-6708 Neuhofen (DE)**
Erfinder : **Winkler, Ekhard, Dr.
Pfalzring 74
W-6704 Mutterstadt (DE)**
Erfinder : **Gotsmann, Guenther, Dr.
Max-Beckmann-Strasse 15
W-6710 Frankenthal (DE)**
Erfinder : **Glaser, Klaus
Neuweg 14
W-6704 Mutterstadt (DE)**
Erfinder : **Fikentscher, Rolf, Dr.
Von-Stephan-Strasse 27
W-6700 Ludwigshafen (DE)**

EP 0 321 855 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft die Verwendung von polymeren Kondensationsprodukten, die Piperazinringe enthalten, gegebenenfalls in Form ihrer quaternären Salze, als Konditionierungsmittel zur Vorbehandlung vor einer Bekeimung nichtmetallischer Oberflächen von Formkörpern für eine nachfolgende vollständige und gleichmäßige Metallisierung.

Die chemische Metallisierung der Oberfläche von nichtmetallischen Materialien dient in der Regel der Erzielung eines dekorativen Effekts, dem Schutz der Materialoberfläche oder aber der Erzielung einer elektrischen Leitfähigkeit der Oberfläche. Beispiele hierfür sind die Vernickelung (mit anschließender galvanischer Verchromung) von Kunststoffteilen im Automobilbau sowie die chemische Verkupferung von Leiterplatten für elektrotechnische und elektronische Geräte. Die chemische Metallisierung wird in mehreren Schritten durchgeführt. Im Falle der chemischen Verkupferung von Leiterplatten (vor allem zur Durchkontaktierung von Bohrlöchern) sind dies die Reinigung, die Anätzung der Kupfer-Kaschierung, das sogenannte "Pre-dip" zum Schutz des nachfolgenden Bades, die Bekeimung mit einem Palladium- oder Kupfer-Kolloid (auch "Aktivierung" genannt), die Entfernung überschüssigen Kolloids (auch "Strippen" genannt) und schließlich die eigentliche chemische Verkupferung. Dabei wird ein gleichmäßiger und vollständiger Kupferbelag angestrebt. Erfahrungsgemäß treten bei der Verkupferung von Bohrlöchern bisweilen Störungen auf, welche darin bestehen, daß die im Bohrloch chemisch abgeschiedene Kupferhülse kleine Löcher aufweist oder aber an einer oder an mehreren Stellen nicht am Grundmaterial der Leiterplatte haftet (Lochwand-Ablösung), was beim Einlöten von Bauteilen zu fehlerhaften Kontakten führt. Auch bei der Beschichtung nichtmetallischer Oberflächen mit anderen Metallen kann es zu ähnlichen Störungen kommen. Es ist somit nötig, bei der chemischen Verkupferung und naturgemäß auch bei den anderen chemischen Metallisierungen eine möglichst gute Porenfreiheit und Haftung zu erzielen.

Dies ist nur dann gewährleistet, wenn bei der Bekeimung die zu metallisierende Oberfläche gleichmäßig mit Kolloid belegt werden kann. Bei glasfaserverstärkten Epoxidharzplatten beispielsweise ist dies jedoch häufig nicht der Fall, da Fasern des Laminats in das Bohrloch hineinragen, wodurch die Bildung von Schwachstellen oder gar Löchern im abgeschiedenen Kupfer hervorgerufen wird.

Die Bekeimung der Oberfläche mit Kolloid kann verbessert werden, wenn der zu metallisierende Gegenstand mit einem Konditionierungsmittel vorbehandelt wird. Dieses Mittel hat die Aufgabe, die Benetzbarkeit der Oberfläche und die Adsorptionsfähigkeit gegenüber dem Kolloid zu verbessern. Das Konditionierungsmittel kann im Reiniger, in einem gesonderten Bad danach oder im "Pre-dip" (Bad vor der Bekeimung) appliziert werden. Am zweckmäßigsten ist der Einsatz im Reiniger.

Bezüglich der Natur des Konditionierungsmittels wurden schon zahlreiche Vorschläge gemacht. So sieht die US-PS 3684572 die Verwendung einer oberflächenaktiven Substanz mit einer quaternären Aminogruppe vor. Die britische Patentanmeldung 2154251 beschreibt die Verwendung eines organischen Amin-Sensibilisierungsmittels, worunter gemäß den Beispielen insbesondere (2,3-Epoxipropyl)-trimethyl-ammoniumchlorid oder 2,3-Dihydroxypropyl-trimethyl-ammoniumchlorid, gemäß der allgemeinen Formel aber auch gewisse niedermolekulare Derivate von Pyridin und Imidazol in quaternisierter Form zu verstehen sind. Die deutsche Offenlegungsschrift 3530617 schließlich offenbart als Konditionierungsmittel quaternisierte Heterocyclen wie Imidazol oder Benzimidazol, die am Stickstoffatom eine Vinyl- oder Allylgruppe besitzen. Die o.g. Konditionierungsmittel besitzen den Nachteil, daß ihre Adsorption an der Oberfläche des zu metallisierenden Materials nicht optimal ist und daß es sich in der letztgenannten Veröffentlichung um ethylenisch ungesättigte Monomere handelt, deren Handhabung aufgrund ihrer Toxizität besondere Sorgfalt erfordert.

Kationische Polymerisate, insbesondere solche, die ein Polyacrylamid-Rückgrad mit daran befestigten Tetraalkylammonium-Gruppen darstellen, werden als Konditioniermittel in der US-Patentschrift 4478883 empfohlen. Es hat sich gezeigt, daß Polymerisate dieser Art nur eine mässige Wirkung haben.

Aufgabe der vorliegenden Erfindung ist es, Konditionierungsmittel zur Vorbehandlung nichtmetallischer Materialien für die nachfolgende Metallisierung zur Verfügung zu stellen, die eine optimale Haftung auf der Oberfläche aufweisen und bei sachgerechter Produktion mit einem Maximum an Sicherheit handhabbar sind.

Die gestellte Aufgabe wird erfüllt durch die Verwendung der in den Ansprüchen 1 bis 3 angeführten polymeren Konditionierungsmittel.

Die erfindungsgemäß zu verwendenden Stoffe sind bekannt bzw. können auf bekannte Weise erhalten werden, beispielsweise gemäß den deutschen Offenlegungsschriften 3526101 (= US-Patentschrift 4704132) und 3621410.

Als Ausgangsstoffe kommen in Betracht (a) Piperazin und seine an einem oder beiden Stickstoffatomen substituierten Derivate, wie 1,4-Bis-(3-aminopropyl)-piperazin, 1-(2-Aminoethyl)-piperazin, 1-(2-Hydroxiethyl)-piperazin, 1,4-Bis-benzyl-piperazin und 1-Methylpiperazin, und (b) Alkylenderivate, die zwei mit den Stickstoffatomen des Piperazinrings reagierende Gruppen enthalten, wie Ethylenchlorid, Epichlorhydrin, Epibromhydrin, 1,2-Propylenchlorid, 1,3-Propylenchlorid, 1,3-Dichlorhydroxipropan, Bis-epoxibutan und 1,4-Dichlorbutan.

Die Ausgangsstoffe können im Molverhältnis (a : b) 1 : 0,5 bis 1,1, vorzugsweise 1 : 0,8 bis 1,0 und besonders bevorzugt 1 : 0,9 bis 0,96 gemäß den Angaben in den oben genannten Offenlegungschriften miteinander umgesetzt werden. Die so erhaltenen Kondensationsprodukte können gewünschtenfalls quaternisiert werden, wobei man die üblichen Quaternisierungsmittel, z.B. Dialkylsulfate, wie Dimethyl- oder Diethylsulfat oder Alkyl- oder Benzylhalogenide, wie Butylbromid, Hexylbromide, Ethylhexylbromid, n-Octylbromid, n-Dodecylbromid, Benzylbromid oder die entsprechenden Chloride, einsetzt.

Die Stickstoffatome in den erfindungsgemäß zu verwendenden Stoffen können bis zu 100% mit $C_1$- bis $C_{12}$-Alkylgruppen und/oder bis zu 80% mit Benzylgruppen quaternisiert sein unter der Bedingung, daß die Quaternisierungsprodukte in dem wäßrigen Anwendungsbad löslich sind. Der erforderliche Grad der Löslichkeit hängt von der gewünschten Anwendungskonzentration ab. Eine Löslichkeit von wenigstens 1 Gew.% im Bad ist unter allen Umständen ausreichend und daher bevorzugt.

Falls die erfindungsgemäß zu verwendenden Stoffe als Quaternärsalze vorliegen, können ihre quaternären Stickstoffatome grundsätzlich durch beliebige Säureanionen kompensiert sein, sofern diese sich nicht auf die Löslichkeit der polymeren Salze negativ auswirken oder aufgrund eigener Reaktivität unerwünschte Störungen bei der Anwendung verursachen. In aller Regel enthalten die polymeren Salze der Einfachheit halber die aus den Quaternisierungsmitteln, die bei ihrer Herstellung eingesetzt worden sind, stammenden Anionen, also vorzugsweise Chlorid-, Bromid-, Methosulfat- und Ethosulfat-Ionen.

Das Molekulargewicht der erfindungsgemäß zu verwendenden Polymeren hat auf deren Wirkung keinen ausgeprägten Einfluß. Es kann davon ausgegangen werden, daß Molekulargewichte ab ca. 1500 ausreichend sind. Die Verwendung besonders hochmolekularer Polymerer bringt keine Vorteile, ist aber möglich. Molekulargewichte von 1900 bis 50000 sind bei der Kondensation leicht zu erreichen und werden daher bevorzugt.

Die erfindungsgemäße Anwendung der oben beschriebenen polymeren Konditionierungsmittel geschieht in einem Bad, in welches der zu metallisierende Gegenstand — z.B. eine Leiterplatte — eingetaucht wird. Auch ein Besprühen des Gegenstandes mit der Lösung des Konditionierungsmittels ist möglich. Die Lösung des Konditionierungsmittels ist wäßrig, d.h. sie enthält als Lösemittel entweder nur Wasser oder überwiegend Wasser neben anderen mit Wasser mischbaren Flüssigkeiten, wie Alkoholen. Die Behandlung des nichtmetallischen Gegenstandes muß vor der Aktivierung durch das Palladium- oder Kupfer-Kolloid erfolgen, da sie sonst wirkungslos ist. Am zweckmäßigsten ist der Einsatz im Reinigungsbad. In den anderen Bädern besteht die Gefahr einer Schädigung des Konditionierungsmittels (z.B. im Ätzbad) oder einer Beeinträchtigung der Löslichkeit durch Salze (z.B. im "Pre-dip", einem Elektrolyte enthaltenden Bad). Der Einsatz in einem Spülbad wäre unökonomisch, ist aber grundsätzlich möglich.

Die benötigte Konzentration des Konditionierungsmittels beträgt 0,001 bis 1 Gew.%, vorzugsweise 0,01 bis 0,2 Gew.%. Die Bad-Temperatur sollte bevorzugt 20 bis 50°C betragen, die Dauer der Anwendung 15 Sec. bis 30 Min., bevorzugt 2 bis 10 Min..

Die erfindungsgemäß einzusetzenden Konditioniermittel kommen für die Vorbehandlung verschiedenster, chemisch zu metallisierender Materialien in Betracht, z.B. von Gegenständen aus Phenolharz/Papier, Epoxidharz, Polystyrol, Polyamid, Polyethylen, Polyvinylchlorid, Polycarbonaten, Polyacrylaten, Polyestern, Polysulfonen oder Polytetrafluorethylen, gegebenenfalls verstärkt oder gefüllt mit Glas, Mineralien oder Polymeren in gewebe-, faser- oder sonstiger Form, oder auch aus Glas oder keramischem Material.

Die folgenden Beispiele zeigen die Wirksamkeit der erfindungsgemäßen Verwendung der polymeren Konditionierungsmittel.

Bei der Prüfung wurde so vorgegangen, daß eine im Handel befindliche Chemisch-Kupfer-Produktlinie mit einer Palladium-Kolloid-Aktivierung und eine andere mit einer Kupfer-Kolloid-Aktivierung verwendet wurden. Die Produkt-Linien bestehen jeweils aus :

| | |
|---|---|
| — Reiniger | |
| — Ätzbad | (Anätzung der Kupfer-Kaschierung) |
| — "Pre-dip" | (Vorbehandlung zur Kolloid-Bekeimung) |
| — Aktivator | (Pd- bzw. Cu-Kolloid) |
| — Stripper | (Entfernung von Kolloid-Überschuß) |
| — Chemish-Kupfer-Bad | (Abscheidungs-Bad). |

Die jeweils zwischengeschalteten Spülbäder sind in dieser Aufstellung nicht enthalten. Die Konditionierungsmittel wurden jeweils dem Reiniger-Bad in einer Konzentration von 0,15 Gew.% zugesetzt. Die einzelnen Bäder hatten ein Volumen von je 50 ml (Reagenzglas im thermostatisierten Wasserbad). Die Temperaturen, die Behandlungsdauern und die Spülungen zwischen den Bädern entsprachen den Vorschriften der Hersteller. Als Substrate wurden verwendet :

— Glasfaser-Gewebestücke, Gewebeart Atlas, Flächengewicht 296 g/m², am Rand mit handelsüblichem Klebstoff fixiert.

— Streifen von glasfaserverstärkten Epoxidharz-Leiterplatten, "FR4" (entsprechend Military Standard Mil-P-13949 E, Klasse GFGF), beidseitig mit Kupferfolie kaschiert und gebohrt.

Die Substrate wurden während der Behandlung im Bad leicht bewegt.

Die Glasfaser-Gewebestücke wurden jeweils 10 Min. im Abscheidungsbad behandelt. Nach Durchlaufen des letzten Spülbades wurden sie in Isopropanol getaucht und dann mit Preßluft getrocknet.

Die Leiterplatten-Stücke wurden in der mit Palladium-Kolloid arbeitenden Produktlinie 9 Min., in der mit Kupfer-Kolloid arbeitenden 7 Min. im Abscheidungsbad belassen und dann mit Preßluft getrocknet. Dabei wird eine dünne Verkupferung mit relativ vielen Fehlstellen (Löchern) erhalten, die jedoch Einflüsse des Konditionierungsmittels sehr gut erkennen läßt. Die Prüfung der Verkupferung der Bohrlöcher der Leiterplatten-Stücke erfolgte anhand von Schliffpräparaten, die unter dem Mikroskop im Durchlicht abgemustert wurden. Diese Methode wird u.a. beschrieben im Jahrbuch Oberflächentechnik 40, 1984, S. 122-133 (H.-J. Ehrich : "Vorteile der alkalischen Aktivierung zur Herstellung hochwertiger Leiterplatten").

Die Beurteilung der verkupferten Substrate erfolgte nach Noten :

| Note | Beurteilung | |
|---|---|---|
| 0 | keine Abscheidung | |
| 1 | sehr mangelhaft | (nur partielle Abscheidung) |
| 2 | mangelhaft | (erheblicher Lichtdurchtritt) |
| 3 | mäßig | |
| 4 | befriedigend | (f. Produktion noch geeignet) |
| 5 | gut | (wenig Löcher bzw. Lichtdurchtritt) |
| 6 | sehr gut | (keine Löcher bzw. Lichtdurchtritt) |

Es sei hier nochmals darauf hingewiesen, daß sich durch die absichtlich vorgenommene dünne Verkupferung bei der Prüfung der Leiterplatten-Stücke schlechte Absolut-Noten ergeben. Die Wirkung der Konditionierungsmittel ergibt sich hier aus der Noten-Differenz.

Es wurden folgende polymeren Konditionierungsmittel geprüft :

I Copolymerisat aus Piperazin und Epichlorhydrin ohne Quaternisierung

II Copolymerisat I, quaternisiert zu 60%, bez. auf N, mit Benzylchlorid

| Beisp.-Nr. | Konditionierungsmittel | Kolloid Pd | Kolloid Cu | Substrat Glas | Substrat L-Pl. | Note | Wirkung = Noten-Diff. |
|---|---|---|---|---|---|---|---|
| Vgl. 1 | - | x | | x | | 3 | - |
| 1 | I | x | | x | | 5 | 2 |
| 2 | II | x | | x | | 5 | 2 |
| Vgl. 2 | - | x | | | x | 2-3 | - |
| 3 | I | x | | | x | 4-5 | 2 |
| Vgl. 3 | - | | x | x | | 3-4 | - |
| 4 | II | | x | x | | 5-6 | 2 |

In einer weiteren Versuchsreihe wurde wie oben angegeben gearbeitet, nur wurde statt des in den Beispielen 1 bis 4 und den Vergleichsbeispielen 1 bis 3 verwendeten, zur Produktlinie gelieferten Reinigerbades ein solches folgender Zusammensetzung eingesetzt

1,6 Gew.% Nonylphenol-ethoxylat (14 EO)

0,6 Gew.% Triethanolamin

0,02 Gew.% Polyvinylpyrrolidon mit dem K-Wert 30

0,04 Gew.% Natriumhydrogenphosphat

Rest bis 100 Gew.% Wasser.

Diesem Bad wurde im Vergleichsbeispiel 4 kein Konditionierungsmittel, in den Vergleichsbeispielen 5 und 6 und dem erfindungsgemäßen Beispiel 5 jeweils 0,5 Gew.% folgender Konditionierungsmittel zugesetzt :

Vergleich 5 :

III Copolymerisat aus 30 Gew.% Acrylamid und 70 Gew.% (2-Acryloyloxyethyl)-trimethylammoniumchlorid (entsprechend US-Patentschrift 4478883) ;

Vergleich 6 :

IV Copolymerisat aus 50 Gew.% Acrylamid und 50 Gew.% (2-Acryloyloxyethyl)-trimethylammoniumchlorid (entsprechend US-Patentschrift 4478883).

Beispiel 5 :

das oben als II bezeichnete Copolymerisat (entsprechend der Erfindung).

Die Abscheidungs-Zeit im Chemisch-Kupfer-Bad betrug 15 Minuten.

Aus der folgenden Tabelle ist ersichtlich, daß das gemäß der Erfindung durchgeführte Beispiel 5 wesentlich bessere Ergebnisse liefert als die nach der Lehre der US-Patentschrift 4478883 durchgeführten Vergleichsbeispiele 5 und 6.

| Beisp.-Nr. | Konditionierungsmittel | Kolloid Pd | Substrat Glas | Note | Wirkung = Noten-Diff. |
|---|---|---|---|---|---|
| Vgl. 4 | - | x | x | 0-1 | - |
| Vgl. 5 | III | x | x | 1 | 0,5 |
| Vgl. 6 | IV | x | x | 1-2 | 1 |
| 5 | II | x | x | 5 | 4,5 |

## Patentansprüche

1. Verwendung von polymeren Kondensationsprodukten, die wiederkehrende Einheiten der Formel

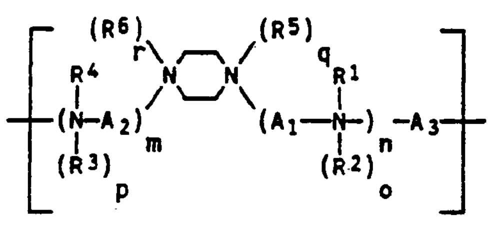

enthalten, wobei

| | |
|---|---|
| $A_1$ und $A_2$ | $C_2$- bis $C_4$-Alkylenreste, |
| $A_3$ | einen gegebenenfalls durch Hydroxyl substituierten $C_2$- bis $C_4$-Alkylenrest, |
| $R^1$ und $R^4$ | Wasserstoff, $C_1$- bis $C_{12}$-Alkylreste oder Benzylreste, |
| $R^2$ und $R^3$ | $C_1$- bis $C_{12}$-Alkylreste oder Benzylreste, |
| $R^5$ und $R^6$ | $C_1$- bis $C_{12}$-Alkylreste, hydroxylsubstituierte $C_2$- bis $C_{12}$-Alkylreste oder Benzylreste und |
| | n, m, o, p, q und r Null oder 1 bedeuten, |
| | als Konditionierungsmittel zur Vorbehandlung nichtmetallischer Oberflächen vor ihrer Bekeimung für eine nachfolgende chemische Metallisierung. |

2.Verwendung eines polymeren Kondensationsproduktes, das wiederkehrende Einheiten der Formel

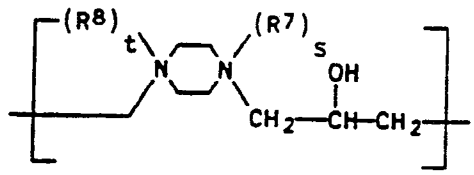

enthält, wobei

| | |
|---|---|
| $R^7$ und $R^8$ | unabhängig voneinander $C_1$-$C_{12}$-Alkylreste oder Benzylreste und |
| s und t | unabhängig voneinander Null oder 1 |
| | bedeuten, gemäß Anspruch 1. |

3.Verwendung eines polymeren Kondensationsproduktes aus Piperazin und einem Epihalogenhydrin, dessen Stickstoffatome zu 0 bis 100% mit $C_1$- bis $C_{12}$-Alkylgruppen oder zu 0 bis 80% mit Benzylgruppen quaternisiert sind, in Form eines im wäßrigen Anwendungsbad löslichen Salzes gemäß Anspruch 1 oder 2.

4.Verwendung von polymeren Kondensationsprodukten gemäß einem der Ansprüche 1 bis 3 in einem wäßrigen Anwendungsbad in einer Konzentration von 0,001 bis 1 Gew.% bei einer Badtemperatur von 0,001 bis 1 Gew.% bei einer Badtemperatur von 10 bis 60°C und einer Anwendungszeit von 15 Sekunden bis 30 Minuten.

## Claims

1. Use of a polymeric condensate which contains repeating units of the formula

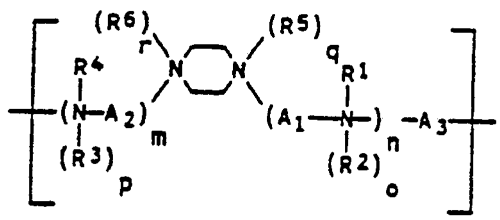

where

| | |
|---|---|
| $A_1$ and $A_2$ | are each $C_2$-$C_4$-alkylene, |
| $A_3$ | is unsubstituted or hydroxyl-substituted $C_2$-$C_4$-alkylene, |
| $R^1$ and $R^4$ | are each hydrogen, $C_1$-$C_{12}$-alkyl or benzyl, |
| $R^2$ and $R^3$ | are each $C_1$-$C_{12}$-alkyl or benzyl, |
| $R^5$ and $R^6$ | are each $C_1$-$C_{12}$-alkyl, hydroxyl-substituted $C_2$-$C_{12}$-alkyl or benzyl and |
| | n, m, o, p, q and r are each zero or 1, as a conditioner for pretreating nonmetallic surfaces prior to their activation for subsequent chemical metallization. |

2. Use of a polymeric condensate which contains repeating units of the formula

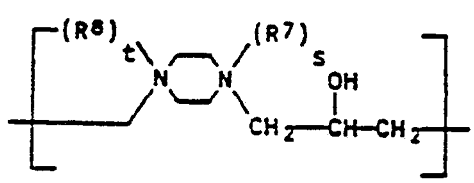

where $R^7$ and $R^8$ independently of one another are each $C_1$-$C_{12}$-alkyl or benzyl and s and t independently of one another are each zero or 1, as claimed in claim 1.

3. Use of a polymeric condensate of piperazine and an epihalohydrin, from 0 to 100% of whose nitrogen atoms have been quaternized with $C_1$-$C_{12}$-alkyl groups or from 0 to 80% of whose nitrogen atoms have been quaternized with benzyl groups, in the form of a salt which is soluble in the aqueous bath used, as claimed in claim 1 or 2.

4. Use of a polymeric condensate as claimed in any one of claims 1 to 3 in an aqueous bath in a concentration of from 0.001 to 1% by weight at a bath temperature of from 10 to 60°C and for from 15 seconds to 30 minutes.

## Revendications

1. Utilisation de produits de condensation polymères qui contiennent des motifs répétitifs de formule

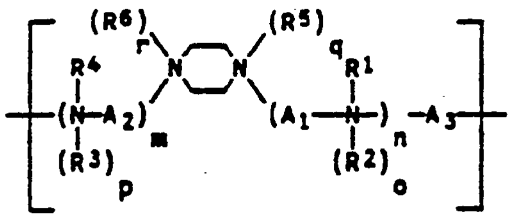

dans laquelle

| | |
|---|---|
| $A_1$ et $A_2$ | représentent des restes alkylène en $C_2$ à $C_4$, |
| $A_3$ | représente un reste alkylène en $C_2$ à $C_4$ éventuellement substitué par un groupement hydroxy, |
| $R^1$ et $R^4$ | représentent chacun un atome d'hydrogène, un reste alkyle en $C_1$ à $C_{12}$ ou un reste benzyle, |
| $R^2$ et $R^3$ | représentent chacun un reste alkyle en $C_1$ à $C_{12}$ ou un reste benzyle, |
| $R^5$ et $R^6$ | représentent chacun un reste alkyle en $C_1$ à $C_{12}$, un reste alkyle en $C_2$ à $C_{12}$ substitué par un groupement hydroxy ou un reste benzyle, |
| | n, m, o, p, q et r sont mis pour 0 ou 1, comme agents de conditionnement pour le pré-traitement de surfaces non métalliques avant leur ensemencement en vue d'une métallisation chimique subséquente. |

2. Utilisation selon la revendication 1 d'un produit de condensation polymère qui contient des motifs répétitifs de formule

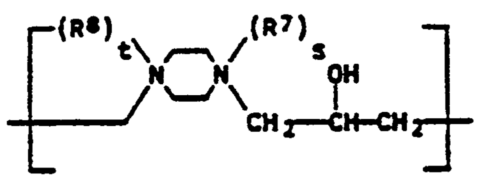

dans laquelle

| | |
|---|---|
| $R^7$ et $R^8$ | représentent, indépendamment l'un de l'autre, des restes alkyle en $C_1$ à $C_{12}$ ou des restes benzyle et |
| s et t | sont mis, indépendamment l'un de l'autre, pour 0 ou 1. |

3. Utilisation selon la revendication 1 ou 2 d'un produit de condensation polymère de pipérazine et d'une épihalogénhydrine, dont les atomes d'azote sont quaternisés à raison de 0 à 100% avec des groupements alkyle en $C_1$ à $C_{12}$ ou à raison de 0 à 80% avec des groupements benzyle, sous la forme d'un sel soluble dans le bain aqueux d'application.

4. Utilisation de produits de condensation polymères selon l'une quelconque des revendications 1 à 3 dans un bain aqueux d'application, à une concentration de 0,001 à 1% en poids, à une température du bain de 10 à 60°C et avec une durée d'application de 15 s à 30 mn.